# EUROPÄISCHE PATENTSCHRIFT

(11) **EP 0 799 487 B1**
(45) Veröffentlichungstag und Bekanntmachung des Hinweises auf die Patenterteilung: **14.07.1999**
(21) Anmeldenummer: 95941585.2
(22) Anmeldetag: 15.12.1995
(51) Int. Cl.: H01F 27/02, H01F 17/02

(54) **ELEKTRISCHES BAUTEIL, INSBESONDERE SPULE, VORZUGSWEISE FÜR SMD-MONTAGETECHNIK**
ELECTRIC COMPONENT, IN PARTICULAR A COIL, PREFERABLY FOR AN SMD ASSEMBLY TECHNIQUE
COMPOSANT ELECTRIQUE, NOTAMMENT BOBINE, DE PREFERENCE POUR TECHNIQUE DE MONTAGE SMD

(30) Priorität: 19.12.1994 DE 9420283 U
(43) Veröffentlichungstag der Anmeldung: 08.10.1997
(60) Teilanmeldung: 98124766.1
(73) Patentinhaber: Hagn, Erwin, 85368 Moosburg (DE)
(72) Erfinder: Hagn, Erwin, 85368 Moosburg (DE)
(74) Vertreter: R.A. KUHNEN & P.A. WACKER
(86) Internationale Anmeldenummer: DE9501797
(87) Internationale Veröffentlichungsnummer: WO9619814

(56) Entgegenhaltungen:
- WO-A-90/13135
- DE-A- 3 615 307
- DE-U- 9 410 532

## Beschreibung

Die Erfindung betrifft ein elektrisches Bauteil, das vorzugsweise für SMD-Montagetechnik (SMD = Surface Mounted Devices) ausgelegt ist, und ist insbesondere auf eine elektrische Spule gerichtet.

Aufgrund der weitgehenden Miniaturisierung von Schaltungen und Schaltplatinen sind üblicherweise auch die Abmessungen der einzelnen elektrischen Bauteile erheblich verringert, was deren manuelle oder automatische Handhabbarkeit beeinträchtigt.

Es hat sich als vorteilhaft erwiesen, zur Handhabung von elektrischen Bauteilen mittels Bestückungsautomaten eine plane Oberfläche bereitzustellen, über die das Bauteil mittels der Ansaugpipette angesaugt werden kann. Es ist bereits bekannt, elektrische Bauteile, die nicht von Haus aus über eine solche plane Oberseite verfügen, vollständig einzukapseln oder mit einer oberseitigen Platte zu versehen. Hierbei erstreckt sich allerdings die Einkapselung oder die oberseitige Platte über die Seitenränder der Bauteile, beispielsweise der Spulen. Dies vergrößert deren seitliche Abmessungen, was in manchen Fällen unerwünscht sein kann. Insbesondere bei mechanischer Abtastung, bei der der Abtast- oder Greifkopf die Seitenränder zur exakten Positionierung des Bauteils in der Sollposition abtastet, kann der Abtastkopf lediglich die Seitenränder des seitlich an dem Bauteil aufgebrachten Verguß- bzw. Plattenmaterials abtasten und erhält somit keine exakte Information über die tatsächliche seitliche Lage des eingegossenen oder mit Platte versehenen Bauteils. Dies kann die Gefahr unerwünschter Fehlpositionierungen begründen. Insbesondere bei Spulen, aber auch bei anderen Bauteilen wie etwa Kapazitäten und dergleichen, kann eine solche Fehlpositionierung schon bei sehr geringem Ausmaß von beispielsweise 0,1 mm dazu führen, daß die elektrische Funktion der das montierte Bauteil enthaltenden elektrischen Gesamtschaltung aufgrund von induktiven oder kapazitiven Abweichungen oder Fehlkontaktierungen beeinträchtigt sein.

Aus der DE-A-36 15 307 ist ein als Luftspule ausgebildetes elektrisches Bauteil bekannt, bei dem zur SMD-Bestükkung mittels einer Ansaugpipette eine plane Schicht an der Oberseite der Spule ausgebildet ist, die genau der vierekkigen Form der Spule entspricht und seitlich nicht über das Bauteil hinausragt.

Einerseits ist aber die Wickeltechnik zum Herstellen derartiger viereckiger Spulen recht aufwendig. Andererseits muß für das Ausbilden der planen Schicht oder einer Einkapselung eine Gußform mit hoher Präzision hergestellt werden.

Hierbei bereitet es auch Schwierigkeiten, das Bauelement exakt in der Gießform so zu positionieren, daß die gewünschte Schichtdicke allseitig erhalten wird und das Bauelement darüber hinaus noch mit seinen Seitenrändern in exakter, vorbestimmter Beziehung zu den Seitenrändern der Gießform und damit der resultierenden Vergußmasse steht. Aufgrund von stets unvermeidlichen Toleranzen kann die Schichtdicke der seitlich an die Seitenränder des Bauteils angrenzenden Schicht variieren, so daß der äußere Seitenrand der Bauteilhülle nicht in stets exakt definierter Beziehung mit der seitlichen Randlage des elektrischen Bauteils, d.h. der eigentlichen Funktionskomponente, beispielsweise der Spule, steht. Eine exakte Positionierung der seitlichen Lage des Gußgehäuses stellt somit nicht sicher, daß auch das darin befindliche elektrische Bauteil mit seinen seitlichen Rändern exakt richtig positioniert ist. Darüber hinaus begründet der Eingießschritt auch generell einen relativ hohen Aufwand.

Der Erfindung liegt die Aufgabe zugrunde, ein elektrisches Bauteil zu schaffen, das kostengünstig herzustellen ist und auch bei SMD-Montagetechnik eine exakte Positionierung ermöglicht.

Diese Aufgabe wird mit den im Anspruch 1 angegebenen Merkmalen gelöst.

Vorteilhafte Ausgestaltungen der Erfindung sind in den Unteransprüchen angegeben.

Bei dem erfindungsgemäßen elektrischen Bauteil ist somit auf einer Bauteilseite, insbesondere der Oberseite, ein Massepunkt mit planer Oberseite angebracht, der nicht über die Seitenkanten des Bauteils hinausragt sondern von diesen beabstandet ist. Mit dieser Gestaltung werden mehrere Vorteile gleichzeitig erreicht. Einerseits ermöglicht die plane Oberfläche des Massepunkts ein zuververlässiges Ergreifen, Hantieren und Ausrichten des Bauteils mittels üblicher Bestückungsautomaten. Selbst Bauteile mit unebener Oberfläche wie etwa Wickelspulen mit kreisförmigem Querschnitt lassen sich somit mit planer Oberfläche versehen, die eine zuverlässige Hantierung erlaubt.

Anderseits ragt der Massepunkt bei dem erfindungsgemäßen elektrischen Bauteil nicht über dessen Seitenränder hinaus, d.h. ist tatsächlich nur auf einer einzigen Bauteilseite aufgebaut. Die Seitenränder des Bauteils bleiben somit frei zugänglich, so daß sie mechanisch oder optoelektrisch zuverlässig abgetastet werden können und ihre jeweilige Lage exakt feststellbar ist. Dies erlaubt eine hohe Präzision bei der Handhabung und/oder Bestükkung bzw. Positionierung der elektrischen Bauteile.

Da der Massepunkt die Seitenränder des elektrischen Bauteils freiläßt, ist er auch in unproblematischer Weise aufbringbar und erfordert keine spezielle Gußform. Beispielsweise ist es möglich, weiches, zum Beispiel erwärmtes Material punktförmig auf die Bauteiloberfläche aufzubringen und dann im noch weichen Zustand mittels einer planen Fläche zu drücken, so daß die Oberfläche des Massepunkts plan wird. Bei Abkühlung erstarrt das Material, so daß das Bauteil zuverlässig über den Massepunkt ergriffen werden kann.

Da für den Massepunkt folglich nur relativ geringe Materialmenge aufzubringen ist, ergibt sich auch keine nennenswerte Erhöhung des Gesamtgewichts des Bauteils, was der präzisen Handhabung gleichfalls zugute kommt.

Die erfindungsgemäße Gestaltung ermöglicht auch eine zuverlässige Handhabung von elektrischen Spulen, deren Windungen gegenseitigen Abstand besitzen. Der Massepunkt stellt eine plane Ansaugfläche auch bei solchen Spulen bereit.

Da der Massepunkt so klein ist, daß er nicht bis zu den Seitenrändern des Bauteils reicht, so daß diese auch von der Seite des Massepunkts aus betrachtet allseits freiliegen, kann das Bauteil auch von der Oberseite ohne Störung durch den Massepunkt ergriffen oder abgetastet werden.

In bevorzugter Ausgestaltung ist der Massepunkt im wesentlichen symmetrisch auf dem Bauteil angeordnet, so daß z. B. eine symmetrische Ansaugung durch die Ansaugpipette eines Bestückungsautomaten möglich ist. Damit ist jegliche Verkippungsgefahr ausgeschaltet. Der Massepunkt ist vorzugsweise in Draufsicht im wesentlichen kreisförmig. Damit läßt sich mit sehr geringem Materialbedarf für den Massepunkt eine großflächige plane Oberfläche ausbilden. Die im wesentlichen kreisförmige Form läßt sich durch Aufbringen eines Massepunkts und Niederdrücken desselben mittels planer Bearbeitungswerkzeugfläche auch in einfacher und definierter Weise herstellen.

Der Massepunkt ist vorzugsweise an der den elektrischen Kontaktanschlüssen gegenüberliegenden Bauteilseite angebracht, so daß sich eine einfache Positionierbarkeit des Bauteils auf einem Schaltungssubstrat ergibt.

In bevorzugter Ausgestaltung ist das Bauteil eine Spule, die durch eine Spiralwicklung gebildet ist. Die Spiralwicklung ist vorzugsweise selbsttragend und stellt damit ein Bauteil mit im wesentlichen zylindrischem Außenumfang dar, das vorzugsweise keinen Magnetkern und kein Magnetjoch besitzt, d.h. als Luftspule ausgebildet ist. Die Spule kann jedoch auch mit Magnetkern versehen sein. Trotz in Axialrichtung gesehener kreisförmiger Krümmung der Spulenoberfläche ergibt sich über den Vergußmassepunkt folglich eine plane Oberfläche, die erleichterte Handhabung ermöglicht.

Gemäß einer besonderen Ausgestaltung besteht der Massepunkt aus Vergußmasse. Die Vergußmasse läßt sich in einfacher Weise in erwärmtem Zustand zum Beispiel tropfenförmig auf das Bauteil auftragen und dann mittels planflächigen Bearbeitungswerkzeugs niederdrücken, so daß sich die Vergußmasse etwas großflächiger auf dem Bauteil verteilt und gleichzeitig eine plane Oberfläche ausbildet. Nach Erstarrung ist die Vergußmasse hoch belastbar.

Vorzugsweise ist der Massepunkt bei Bauteilen mit nicht planer Oberfläche so stark gedrückt, daß die Ebene der Ansaugfläche den höchsten Punkt des Bauteils gerade berührt, d.h. das Bauteil mit seinem höchsten Punkt gerade noch in die Ebene der Ansaugfläche ragt. Dies läßt sich dadurch erreichen, daß das zum Beispiel auf die Vergußmasse drückende Bearbeitungswerkzeug mit planer Oberfläche so stark auf das Bauteil gedrückt wird, daß es dessen Oberfläche kontaktiert. Die Vergußmasse fließt dann soweit zur Seite, daß sich ein Massepunkt ergibt, dessen plane Oberfläche die Bauteiloberseite gewissermaßen tangential berührt. Dies hat den Vorteil, daß die Bauteildicke nicht erhöht wird, so daß der gesamte Raumbedarf des mit Massepunkt versehenen Bauteils weder in Längen- noch in Breiten- oder Dickenrichtung vergrößert wird.

Der Massepunkt kann auch aus ausgehärtetem Klebstoff, beispielsweise Ein- oder Zweikomponenten-Kleber bestehen. Es ist auch möglich, den Massepunkt aus Kunststoff herzustellen, wobei dieser zum Aufbringen des Massepunkts vorzugsweise so stark erwärmt wird, daß er zumindest fließfähig ist, und bei der nachfolgenden Abkühlung wieder erstarrt. Dies ermöglicht eine definierte Formgebung des Massepunkts.

Die Erfindung wird nachstehend anhand von Ausführungsbeispielen unter Bezugnahme auf die Zeichnungen näher beschrieben. Es zeigen:
Figuren 1a, 1b und 1c zwei Seitenansichten und eine Draufsicht auf ein Ausführungsbeispiel des erfindungsgemäßen elektrischen Bauteils in Form einer zylindrischen Spule, und
Fig. 2, die sich aus Zeichnungsteilen a1), a2), b1), b2), c1), c2), d1) und d2) zusammensetzt, Draufsichten und Seitenansichten weiterer Ausführungsbeispiele von erfindungsgemäßen elektrischen Bauteilen.

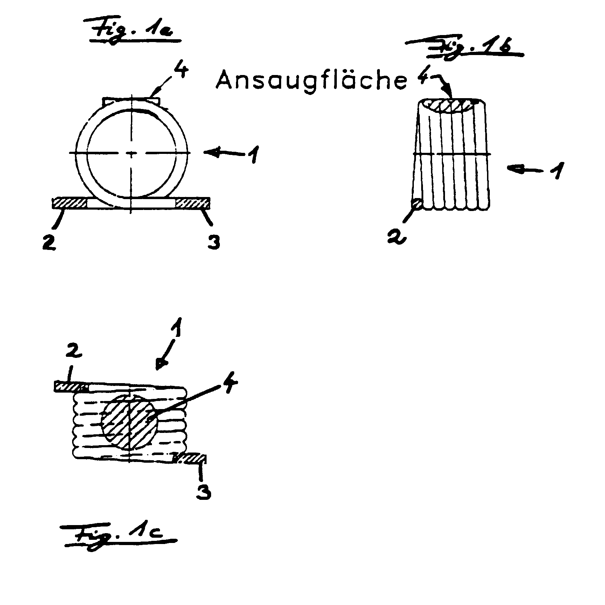

In Fig. 1 ist ein Ausführungsbeispiel des erfindungsgemäßen elektrischen Bauteils in Form einer zylindrisch gewickelten Spule 1 gezeigt, die für SMD-Oberflächenmontage ausgelegt ist. Die Spule 1 enthält eine einzige Wicklungslage und ist magnetkern- und jochfrei, d.h. als Luftspule ausgelegt. Der Spulendrahtdurchmesser ist so groß, daß die Spule stabil und selbsttragend ist. Wie aus den Figuren 1a und 1c ersichtlich ist, liegen die entgegengesetzten Anschlußenden 2, 3 der Spule 1 in einer tangential zur Spule verlaufenden Ebene und sind im Unterschied zum übrigen Bereich des Spulendrahts nicht mit einer Isolation versehen. Die Spule 1 wird bei ihrer Montage mit ihren Anschlußenden 2, 3 auf die zugehörige, nicht dargestellte Leiterplatine aufgesetzt und dort verklebt und/oder verlötet.

Auf der den Anschlußenden 2, 3 gegenüberliegenden Bauteilseite, d.h. der Spulenoberseite, ist ein Massepunkt 4 aufgebracht, der plane Oberfläche besitzt. Die plane Oberfläche des Massepunkts 4 verläuft parallel zur Ebene der Anschlußenden 2, 3, so daß die Spule 1 bei Handhabung mittels Bestückungsautomaten oder dergleichen über die plane Oberfläche des Massepunkts 4 so gehalten werden kann, daß auch die Ebene der Anschlußenden 2, 3 definierte Position besitzt und somit die Spule 1 z. B. verkippungsfrei auf die zugeordnete Leiterplatine aufgesetzt werden kann.

Wie aus den Figuren 1a bis 1c ersichtlich ist, sind die Abmessungen des Massepunkts 4 deutlich kleiner als die axiale Länge und Breite der Spule 1. Damit ragt der Massepunkt 4 nicht nur nicht über die Seitenkanten des elektrischen Bauteils 1 hinaus, sondern endet mit Abstand zu diesen. Damit sind die Seitenkanten des elektrischen Bauteils nicht durch den Massepunkt 4 überdeckt und können folglich exakt und zuverlässig mechanisch oder optoelektrisch abgetastet werden. Auch ist die benötigte Massepunkt-Materialmenge entsprechend gering. Insbesondere aus Fig. 1c ist weiterhin erkennbar, daß der Massepunkt im wesentlichen kreisförmige Gestaltung besitzt, so daß auch die plane Oberfläche im wesentlichen kreisförmig ist. Weiterhin ist ersichtlich, daß der Massepunkt 4 im wesentlichen symmetrisch und mittig auf der Bauteil-Oberseite aufgebracht ist.

Aus den Figuren 1a und 1b ist weiterhin erkennbar, daß der Massepunkt 4 derart auf dem Bauteil, d.h. der Spule 1 aufgebracht ist, daß seine plane Oberfläche im wesentlichen tangential zum Außenumfang der Spulenwicklung verläuft. Dies bedeutet, daß die Dicke des elektrischen Bauteils 1 einschließlich Massepunkt 4 nicht oder allenfalls nur unwesentlich größer ist als die Dicke ohne Massepunkt 4. Die Gesamtdicke bzw. -höhe der Spule 1 ist folglich allenfalls unwesentlich vergrößert, so daß das Bauteil 1 weiterhin äußerst kompakt bleibt.

Das Merkmal, daß die plane Oberfläche im wesentlichen tangential zum Außenumfang der Spulenwindungen verläuft, hat weiterhin zur Folge, daß die Menge des für den Massepunkt benötigten Materials äußerst gering ist, da in der Mitte im wesentlich kein Material aufgebaut wird. Dennoch ergibt sich eine großflächige plane Oberfläche des Massepunkts und damit des entsprechenden Bereichs des erfindungsgemäßen Bauteils, so daß die Handhabung sehr einfach und stabil erfolgen kann. Der Durchmesser des Massepunkts 4 entspricht beim gezeigten Ausführungsbeipiel ungefähr dem halben Durchmesser der Spule 1.

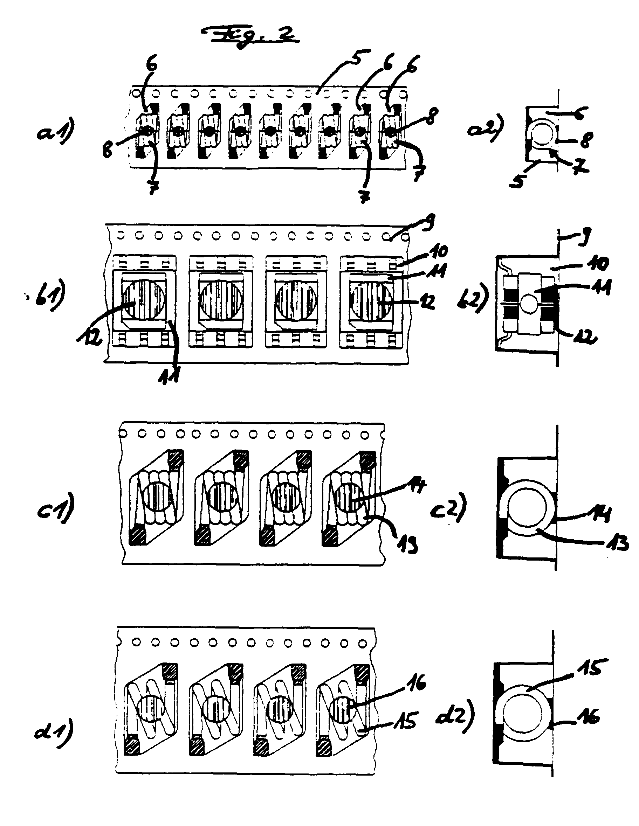

In Fig. 2 sind weitere Ausführungsbeispiele des erfindungsgemäßen Bauteils dargestellt. Hierbei ist in den Teil-Figuren a1) bis d1) jeweils eine Draufsicht auf mehrere, jeweils gleichartige elektrische Bauteile in einer Blisterverpackung gezeigt, während in den rechts daneben dargestellten Figuren a2) bis d2) eine Seitenansicht der jeweiligen Bauteile gezeigt ist.

Aus den Zeichnungen ist ersichtlich, daß der erfindungsgemäße Massepunkt vor allem bei elektrischen Bauteilen mit nicht planer Oberfläche vorteilhaft ist. Allerdings läßt sich der Massepunkt auch auf elektrischen Bauteilen aufbringen, die von Haus aus plane Oberfläche besitzen, insbesondere, wenn die Bauteiloberfläche für sich nicht ausreichend belastbar oder zu spröde sein sollte. Hier kann der Massepunkt auch eine entsprechende Versteifung bewirken und sicherstellen, daß das elektrische Bauteil über die plane Oberfläche des Massepunkts unproblematisch angesaugt werden kann.

In Fig. 2 a1), a2) ist ein Blisterstreifen 5 mit regelmäßig angeordneten Vertiefungen 6 gezeigt. In jede Vertiefung 6 ist jeweils ein Ausführungsbeispiel des erfindungsgemäßen elektrischen Bauteils in Form einer elektrischen Spule 7 eingelegt, wobei sich die Spule 7 jeweils über ihre Anschlußenden-Ebene auf dem Bodenbereich der Vertiefung 6 abstützt. Jede Spule 7 trägt oberseitig einen Massepunkt 8. Über den Massepunkt 8 läßt sich jede Spule 7 selektiv mittels Bestückungsautomat aus dem Blisterstreifen 5 herausnehmen und dann an der gewünschten Position absetzen.

In Fig. 2 b1), b2) ist eine anders geartete Ausführungsform eines erfindungsgemäßen elektrischen Bauteils 11 gezeigt. Auch hier sind mehrere gleichartige elektrische Bauteile 11 in regelmäßig angeordnete Vertiefungen 10 eines Blisterstreifens 9 derart eingelegt, daß sie sich mit ihren Anschlußfahnen auf der Bodenseite der Vertiefungen 10 abstützen. Die Bauteile 11 können beispielsweise kleine Transformatoren mit umgebendem Joch sein. Auf jedem Bauteil 11 ist jeweils ein im wesentlichen kreisförmiger Massepunkt 12 mittig auf der den Anschlußfahnen gegenüberliegenden Oberseite aufgebracht. Der Massepunkt 12 besitzt plane Oberfläche und verleiht der gestuften Oberfläche des Bauteils 11 somit eine plane Oberfläche, die eine zuverlässige Ansaugung ermöglicht.

Wie auch bei den anderen Ausführungsbeispielen besteht das Material des Massepunkts 12 vorzugsweise aus Vergußmasse, die im weichen Zustand auf die Bauteiloberfläche aufgebracht und dann von oben mit planer Bearbeitungsfläche zusammengedrückt wird, so daß sich eine plane Massepunkt-Oberfläche ausbildet.

In Fig. 2 c1), c2) sind weitere Ausführungsbeispiele des erfindungsgemäßen elektrischen Bauteils in Form von elektrischen Spulen 13 gezeigt, die jeweils oberseitig, d.h. auf der den Anschlüssen gegenüberliegenden Seite, mit einem Massepunkt 14 im wesentlichen kreisförmiger Gestaltung versehen sind. Die Spulen 13 besitzen größere Gesamtabmessungen als die Spulen 7 gemäß den Figuren 2 a1), a2), wobei auch der Massepunkt 14 jeweils entsprechend größer ist als der Massepunkt 8. Die einzelnen Windungen der Zylinderspulen 14 sind ohne gegenseitigen Abstand gewickelt, d.h. liegen direkt aneinander an.

In Fig. 2 d1), d2) ist ein abgeändertes Ausführungsbeispiel eines erfindungsgemäßen elektrischen Bauteils in Form einer elektrischen Spule 15 gezeigt. Die Spule 15 ist gleichfalls als Zylinderspule gewickelt, wobei allerdings die Windungen gegenseitigen Abstand haben. Auf der Spulenoberseite ist jeweils ein im wesentlichen kreisförmiger Massepunkt 16 aufgebracht, der eine zuverlässige Ansaugung der Spule trotz des großen gegenseitigen Zwischenabstands der einzelnen Windungen sicherstellt.

Als Material des Massepunkts kann jedes geeignete Material verwendet werden, das eine gewünschte Formgebung erlaubt und im Einsatzzustand ausreichende Festigkeit besitzt.

## Patentansprüche

1. Elektrisches Bauteil, insbesondere Spule (1; 7; 11; 15), vorzugsweise für SMD-Montagetechnik, dadurch gekennzeichnet, daß auf einer Bauteil-Seite, insbesondere der Bauteil-Oberseite, ein Massepunkt (4; 8; 14; 16) aufgebracht ist, der eine plane Oberfläche besitzt und derart angeordnet ist, daß er gegenüber allen Seitenrändern des elektrischen Bauteils beabstandet ist.

2. Bauteil nach Anspruch 1, dadurch gekennzeichnet, daß der Massepunkt (4; 8; 14; 16) im wesentlichen symmetrisch auf dem Bauteil (1; 7; 11; 15) angeordnet ist.

3. Bauteil nach einem der vorhergehenden Ansprüche, dadurch gekennzeichnet, daß der Massepunkt (4; 8; 14; 16) in Draufsicht im wesentlichen kreisförmig ist.

4. Bauteil nach einem der vorhergehenden Ansprüche, dadurch gekennzeichnet, daß der Massepunkt (4; 8; 14; 16) auf der den elektrischen Kontaktanschlüssen (2, 3) des Bauteils (1; 7; 11; 15) gegenüberliegenden Bauteilseite angebracht ist.

5. Bauteil nach einem der vorhergehenden Ansprüche, dadurch gekennzeichnet, daß das Bauteil eine durch eine Spiralwicklung gebildete Spule (1; 7; 11; 15) ist.

6. Bauteil nach einem der vorhergehenden Ansprüche, dadurch gekennzeichnet, daß der Massepunkt aus Vergußmasse besteht.

7. Bauteil nach einem der Ansprüche 1 bis 5, dadurch gekennzeichnet, daß der Massepunkt aus ausgehärtetem Klebstoff besteht.

8. Bauteil nach einem der Ansprüche 1 bis 5, dadurch gekennzeichnet, daß der Massepunkt (4; 8; 14; 16) aus Kunststoff besteht.

## Claims

1. An electric component, especially a coil (1; 7; 11; 15) preferably for SMD assembly technique, characterized in that a mass point (4; 8; 14; 16) having a plane surface and being arranged so that it is spaced apart from all lateral edges of said electric component is applied to one side of the component, especially to the upper side of the component.

2. A component according to claim 1, characterized in that said mass point (4; 8, 14; 16) is arranged substantially symmetrically on said component (1; 7; 11; 15).

3. A component according to any one of the preceding claims, characterized in that, seen from a top view, said mass point (4; 8; 14; 16) is substantially circular.

4. A component according to any one of the preceding claims, characterized in that said mass point (4; 8; 14; 16) is arranged on the side of the component opposing the electric contact terminals (2, 3) of said component (1; 7; 11; 15).

5. A component according to any one of the preceding claims, characterized in that said component is a coil (1; 7; 11; 15) formed by a helical winding.

6. A component according to any one of the preceding claims, characterized in that said mass point consists of a casting compound.

7. A component according to any one of the claims 1 to 5, characterized in that said mass point consists of a cured adhesive.

8. A component according to any one of the claims 1 to 5, characterized in that said mass point (4; 8; 14; 16) consists of a synthetic resin.

## Revendications

1. Composant électrique, notamment bobine (1 ; 7 ; 11 ; 15), de préférence pour une technique de montage SMD, caractérisé en ce que sur une face du composant, notamment la face supérieure, est disposé un point de masse (4 ; 8 ; 14 ; 16), qui possède une surface plane et est disposé de telle sorte qu'il est distant de tous les bords latéraux du composant électrique.

2. Composant selon la revendication 1, caractérisé en ce que le point de masse (4 ; 8 ; 14 ; 16) est disposé d'une manière essentiellement symétrique sur le composant (1 ; 7 ; 11 ; 15).

3. Composant selon l'une des revendications précédentes, caractérisé en ce que le point de masse (4 ; 8 ; 14 ; 16) a une forme sensiblement circulaire selon une vue en plan.

4. Composant selon l'une des revendications précédentes, caractérisé en ce que le point de masse (4 ; 8 ; 14 ; 16) est disposé sur la face du composant, qui est située à l'opposé des bornes électriques de contact (2, 3) du composant (1 ; 7 ; 11 ; 15).

5. Composant selon l'une des revendications précédentes, caractérisé en ce que le composant est une bobine (1 ; 7 ; 11 ; 15) formée par un enroulement hélicoïdal.

6. Composant selon l'une des revendications précédentes, caractérisé en ce que le point de masse est formé d'une masse de scellement.

7. Composant selon l'une des revendications 1 à 5, caractérisé en ce que le point de masse est formé d'une colle durcie.

8. Composant selon l'une des revendications 1 à 5, caractérisé en ce que le point de masse (4 ; 8 ; 14 ; 16) est formé d'une matière plastique.
